# EUROPEAN PATENT SPECIFICATION

(11) **EP 3 745 462 B1**
(45) Date of publication and mention of the grant of the patent: **19.10.2022**
(21) Application number: 20175608.7
(22) Date of filing: 20.05.2020
(51) Int. Cl.: H01L 27/32, H01L 33/44, H01L 33/48, H01L 33/50, H01L 51/52

(54) **OPTICAL DEVICE**
OPTISCHE VORRICHTUNG
DISPOSITIF OPTIQUE

(30) Priority: 30.05.2019 US 201962854958 P; 03.03.2020 CN 202010140334
(43) Date of publication of application: 02.12.2020
(60) Divisional application: 22193284.1
(73) Proprietor: InnoLux Corporation, Chu-Nan, Miao-Li County 35053 (TW)
(72) Inventor: KUO, Shu-Ming, 35053 Chu-Nan, Miao-Li County (TW); HSIEH, Tsau-Hua, 35053 Chu-Nan, Miao-Li County (TW)
(74) Representative: Emde, Eric

(56) References cited:
- CN-A- 108 735 914
- US-A1- 2004 046 184
- US-A1- 2010 289 728
- US-A1- 2019 081 108

## Description

### BACKGROUND OF THE DISCLOSURE

### 1. Field of the Disclosure

The disclosure relates to a technology of an optical device, and more particularly, to a structure of a light emitting panel.

### 2. Description of Related Art

Electronic devices including display panels have been widely used in various aspects of life, such as smart phones, tablet computers and televisions, for displaying images.

A display panel including light emitting units is taken as an example. The display panel includes two substrates disposed opposite to each other. Some member structure layers are first manufactured on individual substrates. Then the two substrates will be pasted together and the member structure layers will be disposed between the two substrates. Therefore, the two substrates are disposed opposite to each other on the outside. Optical members such as a light emitting unit, a wavelength conversion layer and/or a color filter layer are included between the two substrates. Therefore, the optical members are sandwiched between the two substrates.

In the optical members, for example, the wavelength conversion layer is easily affected by moisture and/or oxygen to reduce performance. How to protect an optical member between two substrates is an issue to be considered.

US 2004/0046184 A1 discloses an organic Electro Luminescence, EL, display device which includes an organic EL light emitting element having the first electrode, an organic EL layer and the second electrode formed on a substrate; and a color conversion filter bonded to the organic EL light emitting element and having a color conversion filter layer formed on a transparent substrate. An outer sealing wall and an internal filling portion are formed between the organic EL light emitting element and the color conversion filter. A partition wall is formed between the outer sealing wall and the internal filling portion.

US 2010/0289728 A1 discloses a technique which easily forms a bank the inner lateral surface of which has a part (lower part of the inner lateral surface) made to be lyophilic. The technique provides an organic EL display panel containing a plurality of organic EL elements in which each organic EL element comprises a substrate, an anode disposed on the substrate, an organic light emitting layer disposed on the anode, a cathode disposed on the organic light emitting layer, and a forward-tapered bank which regulates the area of the organic light emitting layer. A lyophobic organic film is disposed on the upper surface of the bank and the surface of the upper part of the tapered portion of the bank but not disposed on the surface of the lower part of the tapered portion of the bank of the organic EL element.

### SUMMARY OF THE DISCLOSURE

The disclosure provides an optical device. Optical members between two substrates may be protected. The invasion of moisture and/or oxygen into the optical device may be reduced. An ability of the optical device to block moisture and/or oxygen is improved accordingly.

According to the present disclosure, an optical device is provided as set forth in claim 1. Preferred embodiments may be gathered from the dependent claims.

For a better understanding of the above and other aspects of the disclosure, the following gives a detailed description of embodiments with reference to accompanying drawings, some of which embodiments are embodiments of the invention, while other embodiments are mere embodiments of the disclosure not falling within the scope of the invention.

### BRIEF DESCRIPTION OF THE DRAWINGS

FIG. 1 is a schematic cross-sectional structure diagram of an optical device.
FIG. 2 is a schematic cross-sectional structure diagram of an optical device according to an embodiment of the disclosure.
FIG. 3 is a schematic cross-sectional structure diagram of an edge of an optical device according to an embodiment of the invention.
FIG. 4A and FIG. 4B are schematic cross-sectional structure diagrams of an optical device according to another embodiment of the disclosure.
FIG. 5A to FIG. 5C are schematic cross-sectional structure diagrams of an optical device according to another embodiment of the disclosure.
FIG. 6A and FIG. 6B are schematic cross-sectional structure diagrams of an optical device according to another embodiment of the disclosure.
FIG. 7 is a schematic cross-sectional structure diagram of an optical device according to another embodiment of the disclosure.

### DESCRIPTION OF THE EMBODIMENTS

In this specification, some embodiments of the disclosure and of the invention are described with reference to the accompanying drawings. Actually, these embodiments may have different deformations, and are not limited to the embodiments in this specification. The same reference symbols in the accompanying drawings are used to indicate the same or similar components.

The invention and the disclosure may be understood with reference to the following detailed description and the accompanying drawings. It should be noted that, for ease of understanding by readers and concise drawings, a plurality of drawings in the disclosure merely show a part of an electronic device, and specific components in the drawings are not drawn to scale. In addition, the quantity and size of the components in the drawings are merely exemplary, and are not intended to limit the scope of the disclosure.

Some words are used to refer to specific components in the whole specification and the appended claims in the disclosure. A person skilled in the art should understand that an electronic device manufacturer may use different names to refer to the same components. This specification is not intended to distinguish components that have the same functions but different names. In this specification and the claims, words such as "include", "comprise", and "have" are open words, and should be interpreted as "including, but not limited to". Therefore, when terms "include", "comprise", and/or "have" are used in the description of the disclosure, the presence of corresponding features, regions, steps, operations and/or components is specified without excluding the presence of one or more other features, regions, steps, operations and/or components.

The directional terms mentioned herein, like "above", "below", "front", "back", "left", and "right", refer to the directions in the accompanying drawings. Therefore, the directional terms are only used for illustration instead of limiting the disclosure. In the accompanying drawings, common features of a method, a structure and/or a material used in a specific embodiment are shown in the drawings. However, these drawings should not be construed as defining or limiting the scope or nature of these embodiments. For example, the relative sizes, thicknesses and positions of films, regions and/or structures may be reduced or enlarged for clarity.

When a corresponding component such as a film or a region is referred to as being "on another component", it may be directly on the another component, or there may be other components between the two components. In another aspect, when a component is referred to as being "directly on another component", there is no component between the two components. In addition, when a component is referred to as being "on another component", the two components have an up and down relationship in a top view. The component may be located above or below the another component, and the up and down relationship depends on the orientation of the device.

It should be understood that, when a component or a film is referred to as being "connected to" another component or film, it may be directly connected to the another component or film, or there are components or films inserted between the two components or films. When a component or a film is referred to as being "directly connected to" another component or film, there is no component or film inserted between the two components or films. In addition, when a component is referred to as being "coupled to another component (or a variant thereof)", it may be directly connected to the another component, or may be indirectly connected to (for example, electrically connected to) the another component through one or more components.

Ordinal numbers used in this specification and the claims, like "first" and "second", are used to modify the components, and do not imply or represent that the (or these) component (or components) has (or have) any ordinal number, and do not indicate any order between a component and another component, or an order in a manufacturing method. These ordinal numbers are merely used to clearly distinguish a component having a name with another component having the same name. Different terms may be used in the claims and the specification, so that a first component in the specification may be a second component in the claims.

In the disclosure, an electronic device may include a display device, an optical device, another suitable electronic device, or a combination of the above devices, but is not limited thereto.

In the disclosure, the optical device may include an organic light-emitting diode (OLED) and an inorganic light-emitting diode (LED), for example, a micro-LED or mini-LED, a quantum dot light-emitting diode (QLED or QDLED) or a similar light-emitting component. A quantum dot (QD) material, a fluorescence material, a phosphor material, another suitable material, or a combination of the above materials may be used in the light-emitting diode, but the disclosure is not limited thereto.

The following describes the technology of the disclosure by listing some embodiments. However, the disclosure is not limited to the listed embodiments, and the embodiments may be combined properly.

An optical device of the disclosure, for example, a light emitting panel of a light emitting diode, may have a better moisture and/or oxygen blocking function, and particularly strengthen the moisture and/or oxygen blocking function on edges of the light emitting panel.

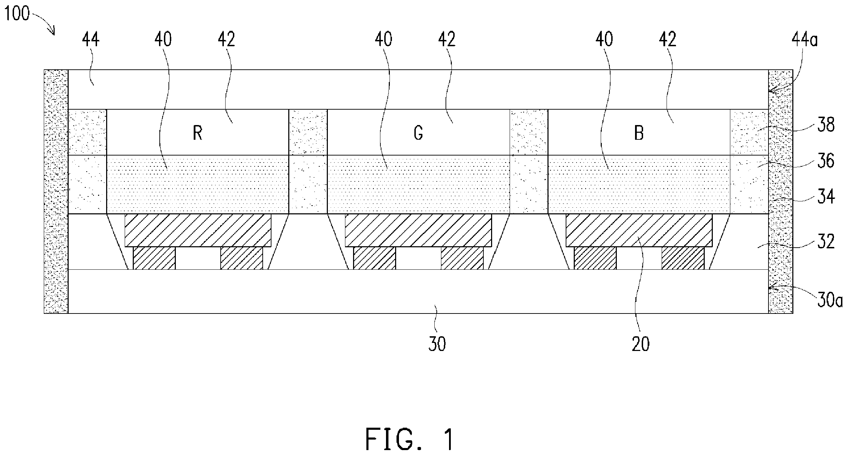

FIG. 1 is a schematic cross-sectional structure diagram of an optical device. Referring to FIG. 1, an optical device 100 includes a structure in which a substrate 30 and a substrate 44 are disposed opposite to each other. Each of the substrate 30 and substrate 44 has a surrounding edge, and the substrate 30 has a side surface 30a and the substrate 44 has a side surface 44a at the surrounding edge, respectively. Optical members are disposed between the substrate 30 and the substrate 44. According to some embodiments, some optical members may be formed on the substrate 30 or the substrate 44 respectively. The substrate 30 and the substrate 44 are then combined together to form the optical device 100.

A pixel definition layer 32 is formed on the substrate 30, and defines a space in which a light emitting unit 20 may be accommodated. The substrate 30 may include, for example, a circuit (not shown) that drives the light emitting unit 20. The light emitting unit 20 is, for example, a light emitting diode. A wavelength of light emitted therefrom is, for example, within a wavelength range of ultraviolet light or blue light. The substrate 30 is, for example, glass or sapphire or the like, which has a low permeability to moisture and/or oxygen.

In addition, for example, a color filter layer 42 is formed on the substrate 44. The color filter layer 42 may include, but is not limited to, a red color filter layer, a green color filter layer and a blue color filter layer. For example, a light blocking layer, for example black matrix (BM) 38 is further included around the color filter layer 42, and isolates the color filter layers 42 of different colors. A bank structure 36 is further formed on the BM 38. A wavelength conversion layer 40 corresponding to the color filter layer 42 is filled in a space surrounded by the bank structure 36. The substrate 44 is also, for example, glass or sapphire or the like, which has a low permeability to moisture and/or oxygen.

After the substrate 30 or the substrate 44 has formed the required optical members thereon respectively, the substrate 30 and the substrate 44 are combined together to form the optical device 100. Each light emitting unit 20 is a sub-pixel corresponding to one color light. The wavelength conversion layer 40 first converts a light emitted from the light emitting unit 20 into another light. Thereafter, the another light passes through the color filter layer 42 to obtain the color light, such as red light, green light or blue light.

In the optical members, for example, the wavelength conversion layer 40 is easily affected by moisture and/or oxygen to reduce quality. Although the substrate 30 or the substrate 44 has a better function of blocking moisture and/or oxygen, the BM 38, the bank structure 36 and/or the pixel definition layer 32 have relatively low moisture and/or oxygen blocking function. When the bank structure 36 and the pixel definition layer 32 are combined together, for example, by adhering, moisture and/or oxygen may also invade from the edges or from a joint surface between the bank structure 36 and the pixel definition layer 32.

The optical device 100 includes a sealing element 34, which is disposed at least along the edges of the substrates 30 and substrate 44 and in contact with the side surface 30a and the side surface 44a of the substrate 30 and the substrate 44 to reduce an opportunity that moisture and/or oxygen may invade from the edge and/or the joint surface. Therefore, a blocking ability of the optical device 100 to prevent moisture and/or oxygen invading from edge is improved.

Preferably, the sealing element 34 is in contact with the side surface 30a of the substrates 30 and the side surface 44a of the substrates 44, and covered thereon. Preferably, the sealing element 34 may seal a joint surface between the bank structure 36 and the pixel definition layer 32.

A material of the sealing element 34 is, for example, a siloxane-containing material or silicon oxide (SiOx), which may block moisture and/or oxygen, but the disclosure is not limited thereto.

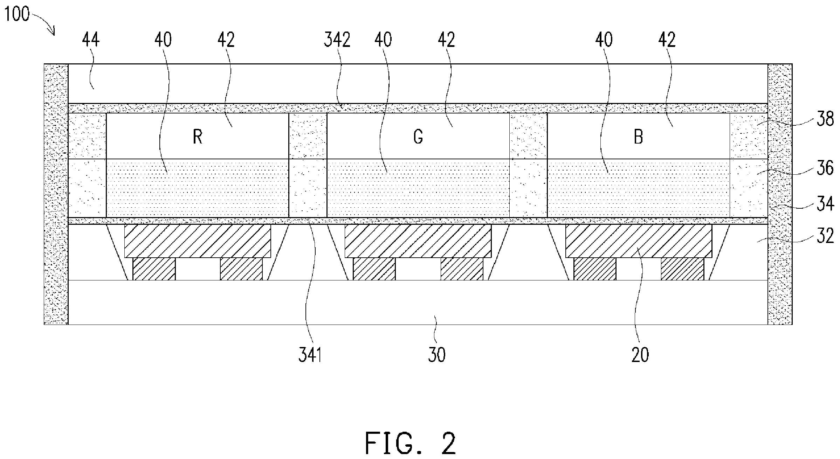

FIG. 2 is a schematic cross-sectional structure diagram of an optical device according to an embodiment of the disclosure. Referring to FIG. 2, the consideration is to increase the protection of the wavelength conversion layer 40. For example, the substrate 44 is a material with higher moisture and/or oxygen permeability, such as, not limited to, Polyimide (PI), Polyethylene Terephthalate (PET), Polycarbonate (PC), Polymethylmetacrylate (PMMA), or similar materials. A moisture blocking layer 342 may be first formed on the substrate 44. In addition, a moisture blocking layer 341 may be formed on a surface of the wavelength conversion layer 40 and the wavelength conversion layer 40 is encapsulated by the moisture blocking layer 341 and the moisture blocking layer 342 which is formed on the substrate 44. After the combination of the substrate 44 and the substrate 30, the sealing element 34 is formed. The moisture blocking layer 342 and the moisture blocking layer 341 may block moisture and/or oxygen, etc., as a blocking layer of moisture and/or oxygen. The sealing element 34 combines the moisture blocking layer 341 and the moisture blocking layer 342 to seal the wavelength conversion layer 40. The blocking ability of the optical device 100 from moisture and/or oxygen may be improved.

The sealing element 34, the moisture blocking layer 341 and/or the moisture blocking layer 342 may be in a fluid state, or may be implemented by coating process or Physical Vapor Deposition (PVD) or Chemical Vapor Deposition (CVD) or similar technologies. The disclosure is not limited thereto.

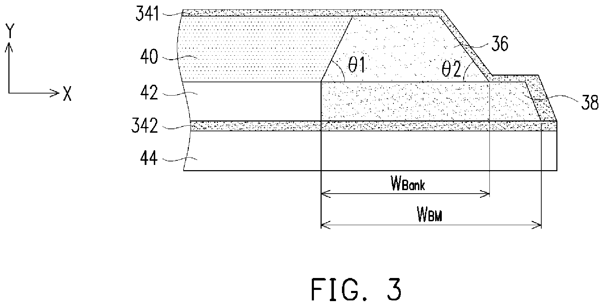

FIG. 3 is a schematic cross-sectional structure diagram of an edge of an optical device according to an embodiment of the invention. Referring to FIG. 2 and FIG. 3, the moisture blocking layer 341 is disposed on the substrate 44. In the flow of a manufacturing process, a structure is formed from the substrate 44 upward. After forming the BM 38, the color filter layer 42, the bank structure 36 and the wavelength conversion layer 40, the moisture blocking layer 341 is formed on the substrate 44. In addition, for example, in the FIG. 2, the moisture blocking layer 341 may cover a part of the surface of the bank structure 36 and/or a part of the surface of the wavelength conversion layer 40. In one embodiment, the moisture blocking layer 341 may also cover a part of the surface of the BM 38 additionally.

In one embodiment, the bank structure 36 on the edge of the optical device has a trapezoid-like cross section shape. The bank structure 36 has a first taper portion on the outer sidewall and is covered by the moisture blocking layer 341. The bank structure 36 has a second taper portion on the inner sidewall and is not covered by the moisture blocking layer 341. In another embodiment, the cross section of the BM 38 may also be in a trapezoid-like shape. The BM 38 has a taper portion on the outer sidewall and is covered by the moisture blocking layer 341. An angle θ2 of the first taper portion of the bank structure 36 is less than an angle θ1 of the second taper portion of the bank structure 36. In addition, a maximum width W_{BM} of the BM 38 is larger than a maximum width WBank of the bank structure 36. For example, from a surface direction parallel to the substrate 44 or a X direction, the maximum width W_{BM} of the BM 38 is larger than the maximum width W_{Bank} of the bank structure 36.

Under geometrical conditions, if the moisture blocking layer 341 is in a fluid state, the moisture blocking layer 341 is easier to cover an outer sidewall of the bank structure 36 and/or the BM 38. In addition, as shown in the structure of the embodiment of FIG. 2, the moisture blocking layer 342 may be first formed on the substrate 44 to protect the wavelength conversion layer 40, the color filter layer 42 and the BM 38.

In one embodiment, when the substrate 44 is a material with low moisture and/or oxygen permeability, the moisture blocking layer 342 may not be required. At this time, the wavelength conversion layer 40 may be sealed by the moisture blocking layer 341 and the substrate 44.

In one embodiment, the substrate 44 and the optical members thereon, such as the wavelength conversion layer 40, the color filter layer 42, the bank structure 36 and the BM 38, may be first covered with the moisture blocking layer 341 to improve an ability to block moisture and/or oxygen, and then combined with the substrate 30 together to form the optical device 100. Thereafter, the sealing element 34 may still be formed on the edge of the optical device 100 to improve the ability of the optical device 100 to block moisture and/or oxygen.

According to the disclosure, the optical device may have various other changes, which are not limited to the illustrated embodiments.

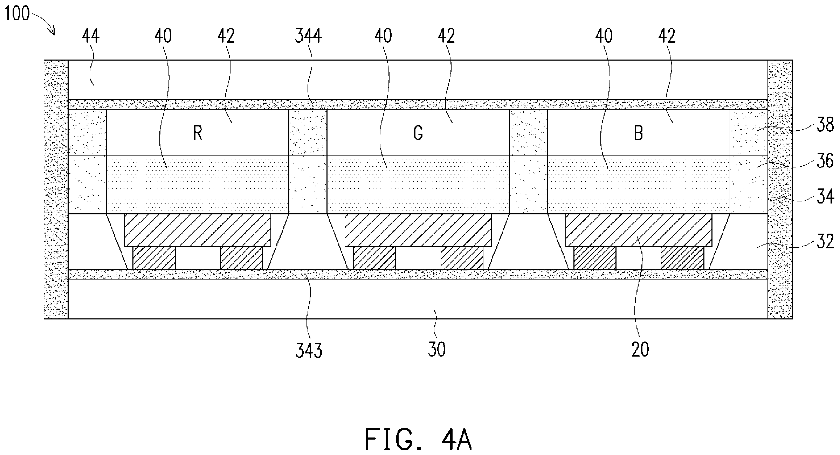

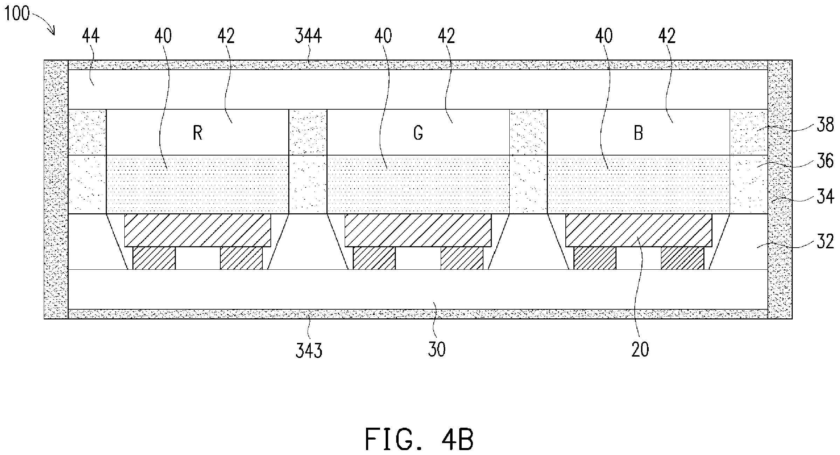

FIG. 4A and FIG. 4B are schematic cross-sectional structure diagrams of an optical device according to another embodiment of the disclosure.

Referring to FIG. 4A, based on the structure of the embodiment of FIG. 1, a part of the embodiment of FIG. 2 is further matched. The optical device 100 in FIG. 4A further includes a moisture blocking layer 343 and a moisture blocking layer 344, which are formed on the substrate 30 and the substrate 44, respectively. The sealing element 34 is jointed with the moisture blocking layer 343 and the moisture blocking layer 344. Therefore, the wavelength conversion layer 40, the color filter layer 42, the bank structure 36, the BM 38, and the light emitting unit 20 may be sealed by the sealing element 34 ,the moisture blocking layer 343 and the moisture blocking layer 344. The ability of the optical device 100 to block moisture and/or oxygen may be improved. The optical members on the substrate 30 and the substrate 44 may be protected. The optical members are as described above and will not be described again here.

Referring to FIG. 4B, similar to the structure of FIG. 4A, the moisture blocking layer 343 and the moisture blocking layer 344 may also be formed on the outside of the substrate 30 and the substrate 44 before the optical member is manufactured. In another embodiment, the moisture blocking layer 343 and the moisture blocking layer 344 may also be formed on the outside of the substrate 30 and the substrate 44 during the process of forming the optical member. In another embodiment, the moisture blocking layer 343 and the moisture blocking layer 344 may also be formed on the outside of the substrate 30 and the substrate 44 after the substrate 30 and the substrate 44 are combined into the optical device 100. After the substrate 30 and the substrate 44 are combined into the optical device 100, the sealing element 34 may be formed on the edge of the optical device 100. Therefore, the wavelength conversion layer 40, the color filter layer 42, the bank structure 36, the BM 38, and the light emitting unit 20 may be sealed by the sealing element 34 ,the moisture blocking layer 343 and the moisture blocking layer 344 to improve the ability of the optical device 100 to block moisture and/or oxygen.

In another embodiments, the wavelength conversion layer and the light emitting unit will be encapsulated by the moisture blocking layer in association with the substrates.

Here, in the FIG. 4A and FIG. 4B, a jointing mechanism between the substrate 30 and the substrate 44 may be designed, for example, in FIG. 3. The substrate 44 is covered by the moisture blocking layer 341, but the disclosure is not limited thereto.

In one embodiment, FIG. 4A and FIG. 4B are based on the substrate 30 and the substrate 44 which are materials with higher moisture and/or oxygen permeability, such as, but not limited to, PI or PC or PMMA.

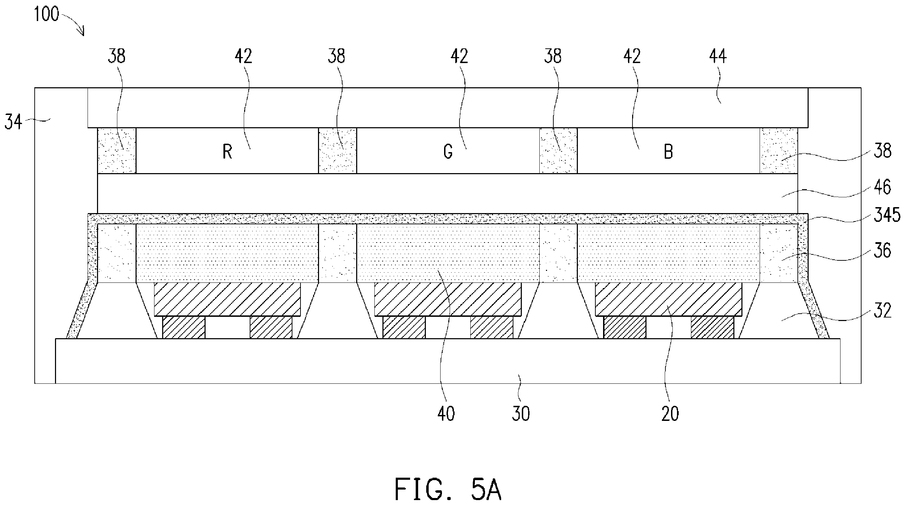

Without departing from the technical concept of the disclosure, the disclosure provides more embodiments of the optical device. FIG. 5A to FIG. 5C are schematic cross-sectional structure diagrams of an optical device according to another embodiment of the disclosure. In the embodiment of FIG. 5A to FIG. 5C, the substrate 30 or the substrate 44 is, for example, but not limited to, glass or sapphire or similar materials with a low permeability to moisture and/or oxygen.

Referring to 5A, based on a manufacturing process on the substrate 30 and the substrate 44, the BM 38 and the color filter layer 42 may be manufactured on the substrate 44. The bank structure 36 and the wavelength conversion layer 40 may be, for example, formed on the substrate 30. Based on the consideration of protecting the wavelength conversion layer 40, in combination with a part of the mode of FIG. 3, a moisture blocking layer 345 may be first formed on the outer sidewall of the bank structure 36 and the outer sidewall of the pixel definition layer 32. The outer sidewall of the pixel definition layer 32 may also be an inclined structure, which is better for the moisture blocking layer 345 to cover the sidewall and contact the substrate 30, and may improve the effect of blocking moisture and/or oxygen.

In addition, the moisture blocking layer 345 may also extend on an upper surface of the bank structure 36 and an upper surface of the wavelength conversion layer 40, that is, cover the optical members disposed on the substrate 30. Here, the moisture blocking layer 345 extends on part of the upper surface of the bank structure 36 and part of the upper surface of the wavelength conversion layer 40, and the moisture blocking layer 345 at least seals the wavelength conversion layer 40 with the substrate 30 to improve an effect of the optical device 100 in blocking moisture and/or oxygen.

The jointing method of the substrate 30 and the substrate 44, for example, the substrate 30 and the substrate 44 may be combined into the optical device 100 by using an adhesive layer 46. The material of the adhesive layer 46 is, for example, a liquid Optical Clear Resin (OCR) or an Optical Clear Adhesive (OCA), a suitable material, or a combination of the foregoing materials. The adhesive layer 46 of the disclosure is not limited to the illustrated mode.

After forming the optical device 100, the sealing element 34 may be formed on the edge of the optical device 100 to reduce the invasion of moisture and/or oxygen from a side and/or a joint surface of the optical device 100.

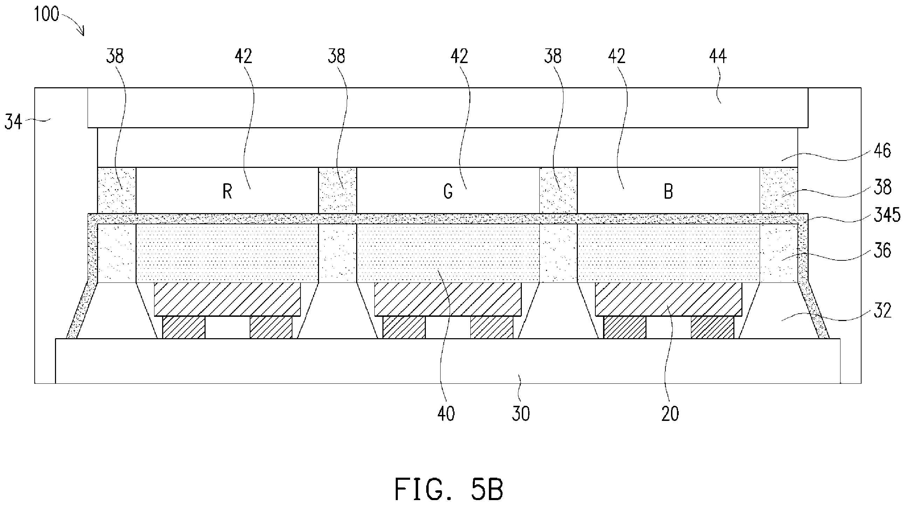

Referring to FIG. 5B, for example, the color filter layer 42 and the BM 38 may also be formed on the substrate 30. In one embodiment, after forming some optical members on the substrate 30, the moisture blocking layer 345 is formed before the BM 38 and the color filter layer 42 are formed. At this time, the substrate 44 may be a transparent substrate, and no optical members are formed thereon, but it is not limited thereto. The substrate 44 is then combined with the substrate 30 by the adhesive layer 46, such as the OCR or the OCA, to form the optical device 100. As described above, the sealing element 34 may be formed on the edge of the optical device 100 to reduce the invasion of moisture and/or oxygen from the side and/or the joint surface of the optical device 100.

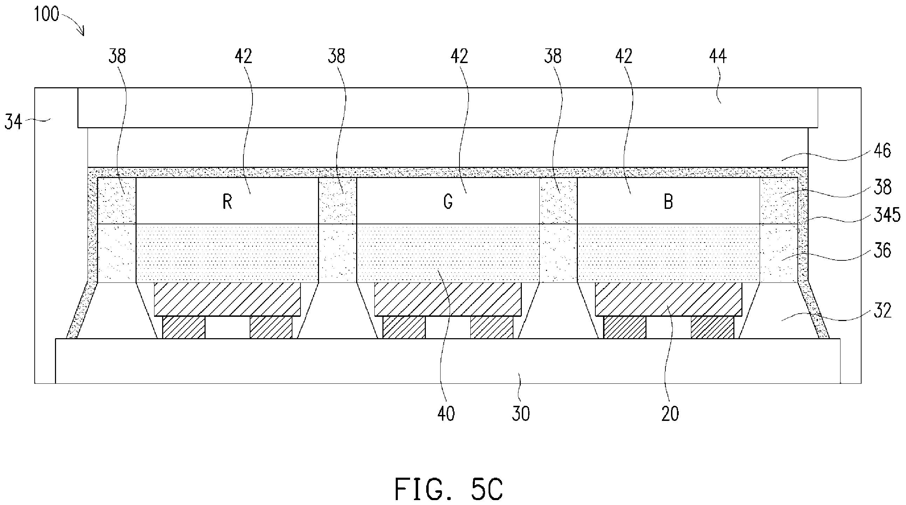

Referring to FIG. 5C, for example, the color filter layer 42 and the BM 38 may also be formed on the substrate 30. In one embodiment, the BM 38 and the color filter layer 42 are formed on the bank structure 36 and the wavelength conversion layer 40 before the moisture blocking layer 345 is formed. Therefore, the moisture blocking layer 345 will cover the color filter layer 42 and the BM 38. Thereafter, the substrate 44 is combined with the substrate 30 to form the optical device 100 by using the adhesive layer 46, such as the OCR or the OCA. As described above, the sealing element 34 may be formed on the edge of the optical device 100 to reduce the invasion of moisture and/or oxygen from the side and/or the joint surface of the optical device 100. At this time, the substrate 44 may be a transparent substrate, and no optical members may be formed on the substrate 44, but it is not limited thereto.

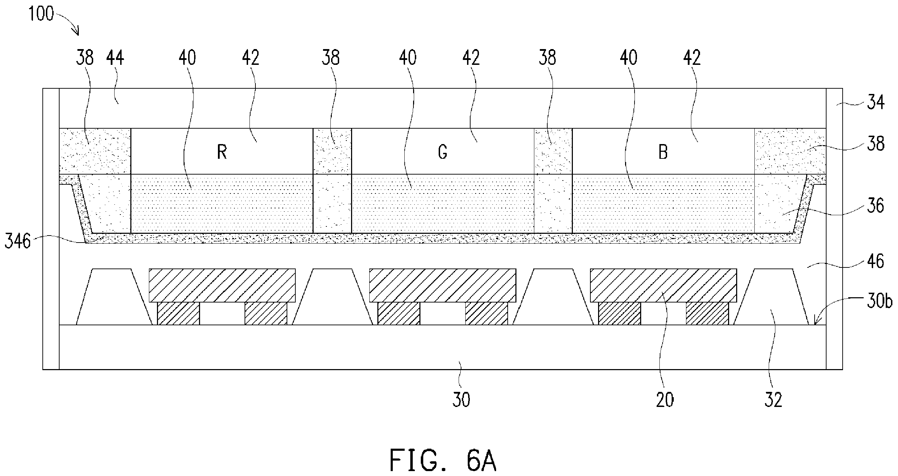

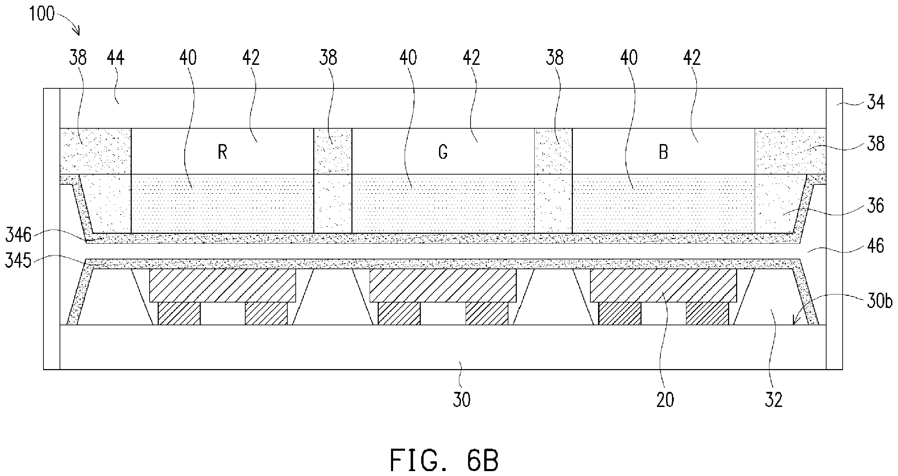

FIG. 6A and FIG. 6B are schematic cross-sectional structure diagrams of an optical device according to another embodiment of the disclosure. In the embodiment of FIG. 6A to FIG. 6B, the substrate 30 or the substrate 44 is, for example, but not limited to, glass or sapphire or similar materials with a low permeability to moisture and/or oxygen. Referring to FIG. 6A, according to a part of the structure of FIG. 3, the optical device may be further modified. Optical members, for example but not limited to, the light emitting unit 20 and the pixel definition layer 32 may be formed on the substrate 30. Optical members including, for example but not limited to, the color filter layer 42, the BM 38, the bank structure 36, the wavelength conversion layer 40 and the moisture blocking layer 346 may be formed on the substrate 44.

The outer sidewall of the pixel definition layer 32 or the outer sidewall of the bank structure 36 also has, for example, a taper portion. The substrate 30 and the substrate 44 are combined into the optical device 100 by, for example, the adhesive layer 46. Thereafter, the sealing element 34 is formed on the edge of the optical device 100 to reduce the invasion of moisture and/or oxygen from the side and/or the joint surface of the optical device 100.

The moisture blocking layer 346 may be selectively not in contact with the substrate 44 and formed on the BM 38 in this embodiment. However, both the sealing element 34 and the moisture blocking layer 346 may reduce the invasion of moisture and/or oxygen from the side and/or the joint surface of the optical device 100.

Referring to FIG. 6B, the structure according to FIG. 6A is further modified. For example, the moisture blocking layer 345 may be further added to cover the optical members on the substrate 30. Here, the moisture blocking layer 345 may selectively cover an upper surface 30b of the substrate 30, or may not cover the upper surface 30b of the substrate 30. In FIG. 6B, the moisture blocking layer 345 is in contact with a part of the upper surface 30b of the substrate 30. The disclosure is not limited to the illustrated mode.

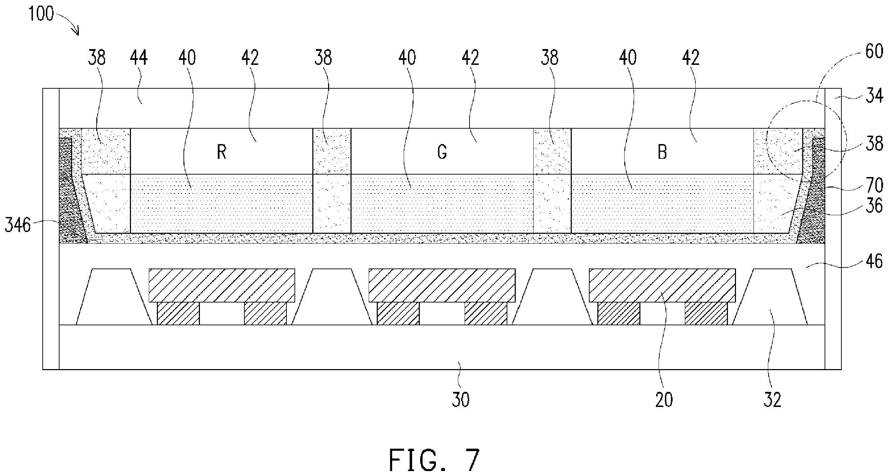

FIG. 7 is a schematic cross-sectional structure diagram of an optical device according to another embodiment of the disclosure. In the embodiment of FIG. 7, the substrate 30 or the substrate 44 is, for example, but not limited to, glass or sapphire or similar materials with a low permeability to moisture and/or oxygen. Referring to FIG. 7, the moisture blocking layer 346 covers the taper portion formed by the BM 38 and the bank structure 36. On a detailed structure of a local area 60, the moisture blocking layer 346 may be selectively in contact with the substrate 44. In one embodiment, a light shielding layer 70 is formed on the edge of the substrate 44 and located on the moisture blocking layer 346. That may further reduce the leakage of light emitted by the light emitting unit 20 from the side. The image quality of the optical device may be improved.

Thereafter, for example, in the same mode of FIG. 6A, the substrate 44 is combined with the substrate 30 via the bonding layer 46 to form the optical device 100. The sealing element 34 is formed on the outside thereof to reduce the invasion of moisture and/or oxygen from the side and/or the joint surface of the optical device 100.

In addition, as described, the embodiments listed may be partially combined to constitute other embodiments. The disclosure is not limited to the embodiments listed.

The scope of the invention is defined by the appended claims.

## Claims

1. An optical device (100), comprising:
two substrates (30, 44) in an opposite arrangement, each of which has a surrounding edge and a side surface (30a, 44a) at the surrounding edge;
a wavelength conversion layer (40) disposed between the substrates (30, 44), wherein the wavelength conversion layer (40) is encapsulated by a moisture blocking layer (341, 342) in association with one of the substrates (30, 44);
a light emitting unit (20) disposed corresponding to the wavelength conversion layer (40) and between the corresponding wavelength conversion layer (40) and one of the substrates (30);
a sealing element (34) sealing the wavelength conversion layer (40) and the light emitting unit (20) between the substrates (30, 44), along the edges and in contact with the side surfaces (30a, 44a) of the substrates (30, 44); and
a bank structure (36) disposed on the one of the substrates (30, 44), **characterised by**
the bank structure (36) having an outer taper portion covered by the moisture blocking layer (341) and an inner taper portion not covered by the moisture blocking layer (341), wherein the inner taper portion is closer to the wavelength conversion layer (40) than the outer taper portion, and wherein an angle (θ2) of the outer taper portion is less than an angle (01) of the inner taper portion.

2. The optical device according to claim 1, wherein the sealing element (34) is made of silicon oxide.

3. The optical device according to claim 1, wherein the sealing element (34) is a coating layer.

4. The optical device according to claim 1, further comprising a light blocking layer (38) disposed between the bank structure (36) and the one of the substrates (30, 44), wherein a width (WBM) of the light blocking layer (38) is greater than a width (W_{BANK}) of the bank structure (36).

5. The optical device according to claim 1, wherein the moisture blocking layer (341) is made of silicon oxide.

## Patentansprüche

1. Optische Vorrichtung (100), die Folgendes aufweist:
zwei Substrate (30, 44) in gegenüberliegender Anordnung, wobei jedes davon eine umlaufende Kante und eine Seitenfläche (30a, 44a) an der umlaufenden Kante hat;
eine Wellenlängenumwandlungsschicht (40), die zwischen den Substraten (30, 44) angeordnet ist, wobei die Wellenlängenumwandlungsschicht durch eine Feuchtigkeitsblockierungsschicht (341, 342) umkapselt ist, die in Assoziation mit einem der Substrate (30, 44) ist;
eine lichtemittierende Einheit (20), die entsprechend der Wellenlängenumwandlungsschicht (40) und zwischen der entsprechenden Wellenlängenumwandlungsschicht (40) und einem der Substrate (30) angeordnet ist;
ein Dichtungselement (34), welches die Wellenlängenumwandlungsschicht (40) und die lichtemittierende Einheit (20) zwischen den Substraten (30, 44) entlang der Kanten und in Kontakt mit den Seitenflächen (30a, 44a) der Substrate (30, 44) abdichtet; und
eine Bankstruktur (36), die an dem einen der Substrate (30, 44) angeordnet ist,
**dadurch gekennzeichnet, dass**
die Bankstruktur (36) einen äußeren verjüngten Teil hat, der durch die Feuchtigkeitsblockierungsschicht (341) bedeckt ist, und einen inneren verjüngten Teil, der nicht durch die Feuchtigkeitsblockierungsschicht (341) bedeckt ist, wobei der innere verjüngte Teil näher an der Wellenlängenumwandlungsschicht (40) ist als der äußere verjüngte Teil, und wobei ein Winkel (θ2) des äußeren verjüngten Teils kleiner ist als ein Winkel (θ1) des inneren verjüngten Teils.

2. Optische Vorrichtung nach Anspruch 1, wobei das Dichtungselement (34) aus Siliziumoxid gemacht ist.

3. Optische Vorrichtung nach Anspruch 1, wobei das Dichtungselement (34) eine Beschichtungsschicht ist.

4. Optische Vorrichtung nach Anspruch 1, die weiter eine Lichtblockierungsschicht (38) aufweist, die zwischen der Bankstruktur (36) und dem einen der Substrate (30, 44) angerordnet ist, wobei eine Breite (W_{BM}) der Lichtblockierungsschicht (38) größer ist als eine Breite (W_{BANK}) der Bankstruktur (36).

5. Optische Vorrichtung nach Anspruch 1, wobei die Feuchtigkeitsblockierungsschicht (341) aus Siliziumoxid gemacht ist.

## Revendications

1. Dispositif optique (100), comprenant :
deux substrats (30, 44) dans un agencement opposé, dont chacun a un bord périphérique et une surface latérale (30a, 44a) au niveau du bord périphérique ;
une couche de conversion de longueur d'onde (40) disposée entre les substrats (30, 44), dans lequel la couche de conversion de longueur d'onde (40) est encapsulée par une couche de blocage de l'humidité (341, 342) en association avec un des substrats (30, 44) ;
une unité d'émission de lumière (20) disposée en correspondance avec la couche de conversion de longueur d'onde (40) et entre la couche de conversion de longueur d'onde correspondante (40) et l'un des substrats (30) ;
un élément de scellement (34) scellant la couche de conversion de longueur d'onde (40) et l'unité d'émission de lumière (20) entre les substrats (30, 44), le long des bords et en contact avec les surfaces latérales (30a, 40a) des substrats (30, 44) ; et
une structure de banc (36) disposée sur l'un des substrats (30, 44), **caractérisé en ce que**
la structure de banc (36) a une partie conique externe recouverte par la couche de blocage de l'humidité (341) et une partie conique interne non recouverte par la couche de blocage de l'humidité (341), dans lequel la partie conique interne est plus proche de la couche de conversion de longueur d'onde (40) que la partie conique externe, et dans lequel un angle (□2) de la partie conique externe est inférieur à un angle (□1) de la partie conique interne.

2. Dispositif optique selon la revendication 1, dans lequel l'élément d'étanchéité (34) est constitué d'oxyde de silicium.

3. Dispositif optique selon la revendication 1, dans lequel l'élément d'étanchéité (34) est une couche de revêtement.

4. Dispositif optique selon la revendication 1, comprenant en outre une couche de blocage de lumière (38) disposée entre la structure de banc (36) et l'un des substrats (30, 44), dans lequel une largeur (W_{BM}) de la couche de blocage de lumière (38) est supérieure à une largeur (W_{BANK}) de la structure de banc (36) .

5. Dispositif optique selon la revendication 1, dans lequel la couche de blocage de l'humidité (341) est constituée d'oxyde de silicium.
